(19) Europäisches Patentamt
European Patent Office
Office européen des brevets

(11) **EP 4 675 684 A1**

(12) **EUROPEAN PATENT APPLICATION**
published in accordance with Art. 153(4) EPC

(43) Date of publication:
**07.01.2026 Bulletin 2026/02**

(21) Application number: **24763448.8**

(22) Date of filing: **26.01.2024**

(51) International Patent Classification (IPC):
*H01L 27/146* (2006.01)  *C08F 220/28* (2006.01)
*G02B 1/118* (2015.01)

(52) Cooperative Patent Classification (CPC):
**C08F 220/28; G02B 1/118; H10F 39/12**

(86) International application number:
**PCT/JP2024/002392**

(87) International publication number:
**WO 2024/180963 (06.09.2024 Gazette 2024/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2023 JP 2023029379**

(71) Applicant: **Dexerials Corporation
Shimotsuke-shi, Tochigi 323-0194 (JP)**

(72) Inventor: **KOKAI, Yuina
Shimotsuke-shi, Tochigi 323-0194 (JP)**

(74) Representative: **Müller-Boré & Partner
Patentanwälte PartG mbB
Friedenheimer Brücke 21
80639 München (DE)**

(54) **METHOD FOR PRODUCING ELECTRONIC DEVICE, AND COVER GLASS**

(57)     Generation of outgassing is restrained to restrain deterioration in optical properties of a cover glass. A method for manufacturing an electronic device includes a baking step of heating the cover glass on which an antireflection layer made of a cured product of a light-curing resin yet to be cured that contains a photopolymerizable component has been formed, an assembling step of installing the cover glass after the baking step at a position opposed to a light receiving surface of a sensor element to assemble a sensor module, and a reflow step of placing the sensor module on a mounting substrate and applying heat at a temperature of more than or equal to 250°C to solder the sensor module to the mounting substrate. The baking step is performed before the reflow step to make a rate of generation of outgassing derived from the photopolymerizable component in outgassing generated from the antireflection layer of the cover glass in the reflow step less than or equal to 0.3 % by mass to mass of the antireflection layer.

FIG.1

**Description**

Technical Field

The present invention relates to a method for manufacturing an electronic device, and a cover glass.

Background Art

An electronic device having a sensor element mounted on a mounting substrate is provided for a portable terminal such as a smartphone, an automobile, a monitoring system, or the like, for example. In the electronic device, the sensor element is covered with a cover glass having an antireflection function in order to improve the sensitivity of the sensor element.

As the cover glass having the antireflection function, a cover glass including an antireflection layer having a micro concave-convex structure and made of resin is being developed. Such a cover glass is manufactured by supplying a curing resin composition to a gap between a master and a base material and curing the curing resin composition to transfer a micro concave-convex structure of the master to a surface of the curing resin composition (the nanoimprinting method) (for example, Patent Literature 1).

Citation List

Patent Literature

Patent Literature 1:      JP 2015-214101A

Summary of Invention

Technical Problem

When the above-described electronic device is manufactured, the cover glass is first installed at a position opposed to a light receiving surface of the sensor element to assemble a sensor module. Then, the sensor module is placed on a mounting substrate and heated, so that the sensor module is soldered (reflowed) to the mounting substrate.

As described above, the sensor module is heated at the time of reflow. This heating generates outgassing from the antireflection layer of the cover glass. Outgassing raises a problem in that the optical properties of the cover glass deteriorate and, in particular, the transmittance of light having a wavelength of more than or equal to 400 nm is reduced.

The present invention was therefore made in view of the above-described problems and has an object to provide a method for manufacturing an electronic device, and a cover glass, which can restrain generation of outgassing to restrain deterioration in optical properties of the cover glass.

Solution to Problem

In order to solve the above-described problems, according to an aspect of the present invention, there is provided a method for manufacturing an electronic device in which a sensor element covered with a cover glass is mounted on a mounting substrate. The cover glass includes a glass substrate, and an antireflection layer provided on a surface on at least one side of the glass substrate and having a micro concave-convex structure having an average cycle of concavities or convexities of less than or equal to a visible light wavelength. The method for manufacturing includes: (1) a transfer step of transferring the micro concave-convex structure of a master to an uncured resin layer provided on the surface on the at least one side of the glass substrate and made of a light-curing resin yet to be cured; (2) a curing step of radiating light to the uncured resin layer to which the micro concave-convex structure has been transferred to cure the uncured resin layer and form the antireflection layer made of a cured product of the light-curing resin; (3) a baking step of heating the cover glass on which the antireflection layer has been formed; (4) an assembling step of installing the cover glass after the baking step at a position opposed to a light receiving surface of the sensor element to assemble a sensor module; and (5) a reflow step of placing the sensor module on the mounting substrate and applying heat at a temperature of more than or equal to 250°C to solder the sensor module to the mounting substrate. The light-curing resin yet to be cured contains a photopolymerizable component. The photopolymerizable component contains a resin (A) and a resin (B). The resin (A) is a monofunctional acrylate monomer having a phenyl group. The resin (B) is a bifunctional or higher functional acrylate monomer. The resin (A) has a content rate of more than 10 % by mass and less than or equal to 40 % by mass to a whole of the photopolymerizable component. The resin (B) has a content rate of more than or equal to 60 % by mass and less than 90 % by mass to the whole of the photopolymerizable component. The baking step is performed before the reflow step to make a rate of generation of outgassing derived from the photopolymerizable component in outgassing generated from the antireflection layer of the cover glass in the reflow step less than or equal to 0.3 % by mass to mass of the antireflection layer.

A rate of generation of outgassing derived from the resin (A) in the outgassing generated from the antireflection layer of the cover glass in the reflow step may be less than 0.2 % by mass.

The resin (B) may be a monomer having a ring structure in a molecule.

The cover glass on which the antireflection layer has been formed may be heated at a temperature of more than or equal to 150°C and less than 250°C for more than or equal to 10 minutes in the baking step.

The antireflection layer may be provided on surfaces on both sides of the glass substrate. In the transfer step, the micro concave-convex structure of the master may be transferred to the uncured resin layer provided on the surfaces on both the sides of the glass substrate.

The sensor element may be an image sensor.

In order to solve the above-described problems, according to another aspect of the present invention, there is provided a method for manufacturing an electronic device in which a sensor element covered with a cover glass is mounted on a mounting substrate. The cover glass includes a glass substrate, and an antireflection layer provided on a surface on at least one side of the glass substrate and having a micro concave-convex structure having an average cycle of concavities or convexities of less than or equal to a visible light wavelength. The method for manufacturing includes: (1) a transfer step of transferring the micro concave-convex structure of a master to an uncured resin layer provided on the surface on the at least one side of the glass substrate and made of a light-curing resin yet to be cured; (2) a curing step of radiating light to the uncured resin layer to which the micro concave-convex structure has been transferred to cure the uncured resin layer and form the antireflection layer made of a cured product of the light-curing resin; (3) a baking step of heating the cover glass on which the antireflection layer has been formed; (4) an assembling step of installing the cover glass after the baking step at a position opposed to a light receiving surface of the sensor element to assemble a sensor module; and (5) a reflow step of placing the sensor module on the mounting substrate and applying heat at a temperature of more than or equal to 250°C to solder the sensor module to the mounting substrate. The light-curing resin yet to be cured contains a photopolymerizable component. The photopolymerizable component contains a resin (A) and a resin (B). The resin (A) is a monofunctional acrylate monomer having a phenyl group. The resin (B) is a bifunctional or higher functional acrylate monomer. The resin (A) has a content rate of more than 10 % by mass and less than or equal to 40 % by mass to a whole of the photopolymerizable component. The resin (B) has a content rate of more than or equal to 60 % by mass and less than 90 % by mass to the whole of the photopolymerizable component. The cover glass on which the antireflection layer has been formed is heated at a temperature of more than or equal to 150°C and less than 250°C for more than or equal to 10 minutes in the baking step.

The baking step may be performed before the reflow step to make a rate of generation of outgassing derived from the photopolymerizable component in outgassing generated from the antireflection layer of the cover glass in the reflow step less than or equal to 0.3 % by mass to mass of the antireflection layer.

In order to solve the above-described problems, according to another aspect of the present invention, there is provided a cover glass that covers a sensor element mounted on a mounting substrate of an electronic device. The cover glass includes: a glass substrate; and an antireflection layer provided on a surface on at least one side of the glass substrate, having a micro concave-convex structure having an average cycle of concavities or convexities of less than or equal to a visible light wavelength, and made of a cured product of a light-curing resin. The cured product of the light-curing resin is a polymer of a resin (A) and a resin (B). The resin (A) is a monofunctional acrylate monomer having a phenyl group. The resin (B) is a bifunctional or higher functional acrylate monomer. The remaining monomer derived from the resin (A) contained in the polymer has a content rate of less than or equal to 0.25 % by mass.

Advantageous Effects of Invention

According to the present invention, generation of outgassing can be restrained to restrain deterioration in optical properties of the cover glass.

Brief Description of Drawings

[FIG. 1] FIG. 1 is a flowchart describing a method for manufacturing an electronic device according to an embodiment of the present invention.

[FIG. 2] FIG. 2 is a process drawing describing a cleaning and pretreatment step, a resin layer forming step, a transfer step, a curing step, a demolding step, and a post-curing step according to the embodiment of the present invention.
[FIG. 3] FIG. 3 is a process drawing describing a baking step according to the embodiment of the present invention.
[FIG. 4] FIG. 4 is a drawing describing an antireflection layer according to the embodiment of the present invention.
[FIG. 5] FIG. 5 is a process drawing describing an assembling step according to the embodiment of the present invention.
[FIG. 6] FIG. 6 is a process drawing describing a reflow step according to the embodiment of the present invention.

Description of Embodiments

Hereinafter, an embodiment of the present invention will be described in detail with reference to the appended drawings. Dimensions, materials, and other specific numerical values and the like indicated in such an embodiment are mere exemplifications for ease of understanding of the invention, and are not intended to limit the present invention unless otherwise specified. Note that, in the present specification and the drawings, elements having substantially the same function and configuration are denoted with the same reference numerals, and repeated explanation thereof is omitted. Illustration of elements not directly pertinent to the present invention is also omitted.
Note that, in the respective drawings which will be referred to in the following description, sizes of some components are expressed exaggeratingly in some cases for ease of description. Therefore, relative sizes of components depicted in the respective drawings do not necessarily express an actual size relationship among the components.

[1. Method for Manufacturing Electronic Device]

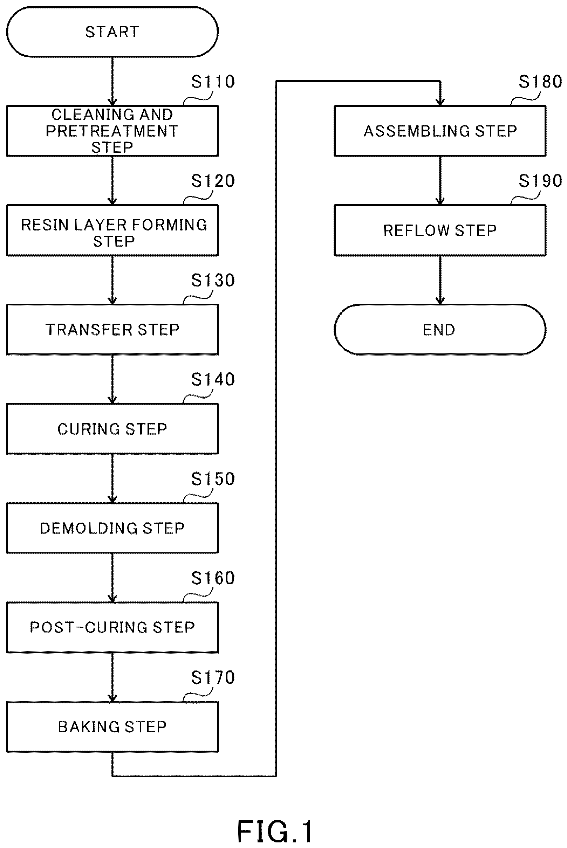

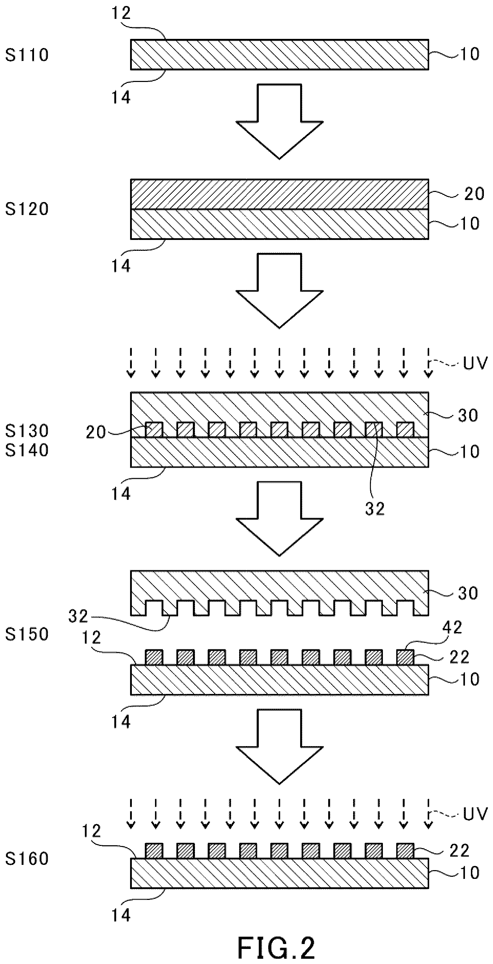

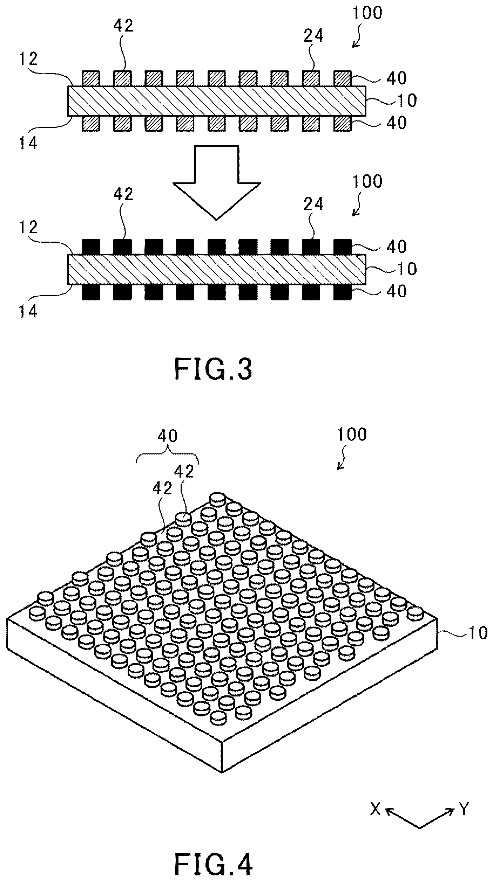

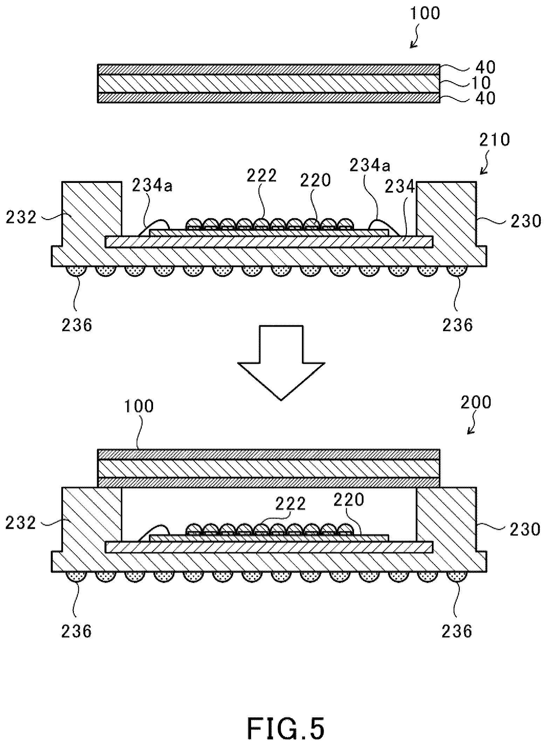

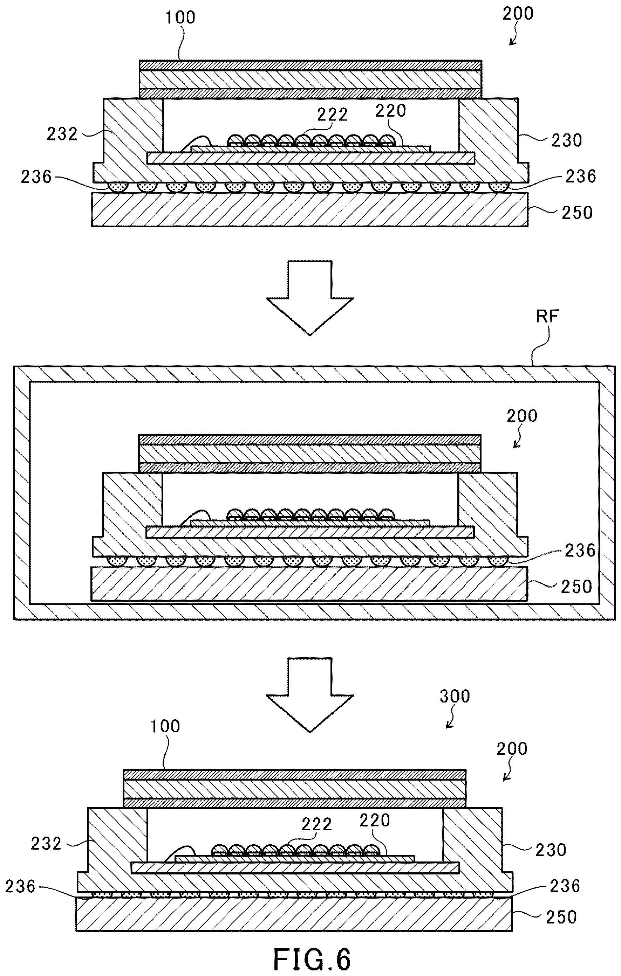

First, a method for manufacturing an electronic device 300 according to an embodiment of the present invention will be described with reference to FIG. 1 to FIG. 6. FIG. 1 is a flowchart describing the method for manufacturing the electronic device 300 according to the embodiment of the present invention. FIG. 2 is a process drawing describing a cleaning and pretreatment step S110, a resin layer forming step S120, a transfer step S130, a curing step S140, a demolding step S150, and a post-curing step S160 according to the embodiment of the present invention. Note that, in FIG. 2, illustration of treatment performed on a surface 14 is omitted for ease of understanding. FIG. 3 is a process drawing describing a baking step S170 according to the embodiment of the present invention. FIG. 4 is a drawing describing an antireflection layer 40 according to the embodiment of the present invention. FIG. 5 is a process drawing describing an assembling step S180 according to the embodiment of the present invention. FIG. 6 is a process drawing describing a reflow step S190 according to the embodiment of the present invention.
As shown in FIG. 1, the method for manufacturing the electronic device 300 according to the present embodiment includes, for example, the cleaning and pretreatment step S110, the resin layer forming step S120, the transfer step S130, the curing step S140, the demolding step S150, the post-curing step S160, the baking step S170, the assembling step S180, and the reflow step S190. Hereinafter, each step will be described.

[Cleaning and Pretreatment Step S110]

First, a glass substrate 10 is cleaned. The glass substrate 10 is formed of a transparent material such as alkali-free glass, borosilicate glass, quartz, or sapphire, for example.
Then, as shown in FIG. 2, a surface 12 of the glass substrate 10 and the surface 14 on the opposite side of the surface 12 are subjected to pretreatment and silane treatment.
The pretreatment is corona discharge surface treatment, blast surface treatment, plasma surface treatment, excimer surface treatment, flame surface treatment, etching, polishing, or the like, for example. The silane treatment is performed by spin coating the surfaces 12 and 14 of the glass substrate 10 with a primer and applying heat. The primer is a silane coupling agent. For example, the primer is "KBM5103", "KBM603", "KBM403", or "X-12-1048" manufactured by Shin-Etsu Chemical Co., Ltd.

[Resin Layer Forming Step S120]

As shown in FIG. 2, an uncured resin layer 20 is formed on the surfaces 12 and 14 on both sides of the glass substrate 10. The uncured resin layer 20 may be formed by coating the surface 12 of the glass substrate 10 with a light-curing resin yet to be cured using an applicator device not shown, for example. Alternatively, the uncured resin layer 20 may be formed by dropping a light-curing resin yet to be cured onto the surface 12 of the glass substrate 10. That is, the uncured resin layer 20 is made of the light-curing resin yet to be cured.
The light-curing resin yet to be cured contains, for example, a photopolymerizable component and a photopolymerization initiator. The photopolymerizable component contains a resin (A) and a resin (B). In the present embodiment, the photopolymerizable component is made of the resin (A) and the resin (B), for example. The resin (A) is a monofunctional acrylate monomer. The resin (B) is a bifunctional or higher functional acrylate monomer.

In the present embodiment, the resin (A) has a content rate of more than 10 % by mass and more than or equal to 40 % by mass to the whole of the photopolymerizable component and the resin (B) has a content rate of more than or equal to 60 % by mass and less than 90 % by mass to the whole of the photopolymerizable component.

When the content rate of the resin (A) contained in the photopolymerizable component is less than or equal to the content rate of the resin (B), the amount of generation of outgassing in the reflow step S190 which will be described later can be reduced. In addition, when the electronic device 300 is assembled, parallel transmittance of a cover glass 100 can be improved. Moreover, heat resistance of the antireflection layer 40 which will be described later can be improved.

The resin (A) is a monofunctional acrylate monomer having a phenyl group. The resin (A) is, for example, either one or both of phenylethyl acrylate and benzyl acrylate. The resin (A) has a phenyl group and the resin (A) thus has a rigid carbon skeleton. Thus, when the photopolymerizable component contains the resin (A), the heat resistance of the antireflection layer 40 can be improved.

The resin (B) preferably is a bifunctional or higher functional acrylate monomer having a ring structure in the molecule. When the photopolymerizable component contains a bifunctional or higher functional acrylate monomer having a ring structure in the molecule as the resin (B), the heat resistance can be improved.

Thus, when the photopolymerizable component contains a bifunctional or higher functional acrylate monomer having a ring structure in the molecule as the resin (B), the amount of generation of outgassing in the reflow step S190 can be reduced.

The resin (B) preferably is one or more of monomers selected from the group of dipentaerythritol hexaacrylate, acrylic acid 2-[5-ethyl-5-[(acryloyloxy)methyl]-1,3-dioxane-2-yl]-2,2-dimethylethyl, trimethylolpropane triacrylate, and 1,6-hexanediol diacrylate and more preferably is dipentaerythritol hexaacrylate and acrylic acid 2-[5-ethyl-5-[(acryloyloxy)methyl]-1,3-dioxane-2-yl]-2,2-dimethylethyl. For example, "DPHA" manufactured by Nippon Kayaku Co., Ltd. can be used as dipentaerythritol hexaacrylate. In addition, for example, "KAYARAD R-604" manufactured by Nippon Kayaku Co., Ltd. can be used as acrylic acid 2-[5-ethyl-5-[(acryloyloxy)methyl]-1,3-dioxane-2-yl]-2,2-dimethylethyl.

The photopolymerization initiator according to the present embodiment is, for example, an acylphosphine oxide-based photopolymerization initiator or an alkylphenone-based photopolymerization initiator. For example, "Irgacure 184" manufactured by IGM Resins B.V. can be used as the photopolymerization initiator.

In addition, the light-curing resin yet to be cured may contain other components (additives). The other components are, for example, an antioxidant, a phosphor, a plasticizer, an ultraviolet absorber, an antifoaming agent, a thixotropic agent, a polymerization inhibitor, a mold release agent, a metal oxide particle, and the like.

[Transfer Step S130]

The transfer step S130 is a step of transferring a micro concave-convex structure 32 of a master 30 to the uncured resin layer 20 provided on the surfaces 12 and 14 on both the sides of the glass substrate 10.

As shown in FIG. 2, the master 30 is pressed against the uncured resin layer 20, and the micro concave-convex structure 32 of the master 30 is transferred to the uncured resin layer 20 to form a micro concave-convex structure 42 on the uncured resin layer 20. Note that an average cycle of concavities or convexities in the micro concave-convex structure 42 is less than or equal to a visible light wavelength. Herein, the average cycle of concavities or convexities is equivalent to a pitch between a plurality of convexities (or a pitch between a plurality of concavities) of the micro concave-convex structure 32. Such an average cycle of concavities or convexities is set at less than or equal to any wavelength in a wavelength band of visible light in accordance with desired antireflection properties of the antireflection layer 40 included in the cover glass 100. In a case in which the wavelength band of visible light is 360 nm to 830 nm, for example, the average cycle of concavities or convexities may be less than or equal to 830 nm, less than or equal to 360 nm, or the like, for example. In addition, in the present embodiment, the master 30 preferably is formed of a material that can transmit light (for example, ultraviolet rays).

[Curing Step S140]

The curing step S 140 is a step of radiating light to the uncured resin layer 20 to which the micro concave-convex structure 42 has been transferred, thereby curing the uncured resin layer 20.

As described above, the master 30 is formed of a material that can transmit light in the present embodiment. Therefore, as shown in FIG. 2, light is radiated to the uncured resin layer 20 in a state in which the master 30 is pressed against the uncured resin layer 20. The uncured resin layer 20 on the glass substrate 10 is thereby cured. That is, the transfer step S130 and the curing step S140 are performed simultaneously (in parallel) in the present embodiment.

EP 4 675 684 A1

[Demolding Step S150]

After the uncured resin layer 20 is cured, the master 30 is demolded from an uncured resin layer 22 having been cured.

[Post-Curing Step S160]

Light is further radiated to the uncured resin layer 22 after demolding to promote curing of the uncured resin layer 22.

Thus, as shown in FIG. 3, the antireflection layer 40 made of a cured product 24 of the light-curing resin and having the micro concave-convex structure 42 having an average cycle of concavities or convexities of less than or equal to a visible light wavelength is formed on the surface 12 of the glass substrate 10.

As shown in FIG. 4, the micro concave-convex structure 42 may be what is called a moth-eye structure, for example. For example, the convexities and concavities of the micro concave-convex structure 42 are arrayed in the X direction and the Y direction on the surface 12 (the XY plane) of the glass substrate 10. By virtue of the micro concave-convex structure 42 formed on the surface of the antireflection layer 40, the cover glass 100 can be provided with an antireflection function in accordance with the average cycle of concavities or convexities of the micro concave-convex structure 42.

In addition, in the present embodiment, the other surface 14 (rear surface) of the glass substrate 10 is also subjected to treatment similar to the above-described treatment performed on the surface 12 to form the antireflection layer 40 on the other surface 14, as shown in FIG. 3.

Thus, the cover glass 100 with the antireflection layer 40 formed on the surfaces 12 and 14 on both the sides of the glass substrate 10 is manufactured. However, the cover glass 100 is not limited to such an example, and the antireflection layer 40 may be formed only on one of the surfaces of the glass substrate 10.

[Baking Step S170]

The baking step S170 is a step of heating the cover glass 100. The baking step S170 is a step of performing heat treatment as pretreatment for the reflow step S190 which will be described later. In the present embodiment, the cover glass 100 is heated in the baking step S170 at a temperature of more than or equal to 150°C and less than 250°C for more than or equal to 10 minutes.

When the temperature for heating the cover glass 100 is less than 150°C, the amount of generation of outgassing derived from the photopolymerizable component contained in the antireflection layer 40 (which hereinafter may simply be referred to as "monomer-derived outgassing") is small. In other words, when the temperature for heating the cover glass 100 is less than 150°C, a large amount of the photopolymerizable component contained in the antireflection layer 40 remains. Then, when the reflow step S190 is executed, a large amount of the monomer-derived outgassing will be generated.

Thus, by heating the cover glass 100 at a temperature of more than or equal to 150°C in the baking step S170, the monomer-derived outgassing can be generated suitably from the antireflection layer 40 to reduce the remaining amount of the photopolymerizable component contained in the antireflection layer 40. This can reduce the amount of generation of the monomer-derived outgassing from the cover glass 100 in the reflow step S190 which is the subsequent step.

On the other hand, when the temperature for heating the cover glass 100 is more than or equal to 250°C, the antireflection layer 40 constituting the cover glass 100 will be denatured to reduce the parallel transmittance of the cover glass 100.

Thus, in the present embodiment, the cover glass 100 is heated at a temperature of less than 250°C in the baking step S170. This can prevent the parallel transmittance of the cover glass 100 from being reduced after the baking step S170 is executed.

If described specifically, when the baking step S170 for the cover glass 100 is performed, the parallel transmittance of the cover glass 100 for light having a wavelength of 400 nm is more than or equal to 96%, for example. In addition, the parallel transmittance of the cover glass 100 for light having a wavelength of 550 nm is more than or equal to 98%, for example. The parallel transmittance of the cover glass 100 for light having a wavelength of 650 nm is more than or equal to 98.5%, for example. In addition, the parallel transmittance of the cover glass 100 for light having a wavelength of 900 nm is more than or equal to 98%, for example.

Note that the parallel transmittance is calculated based on Expression (1) below.

$$\text{Parallel Transmittance } [\%] = (I/I_0) \times 100 \quad \text{... Expression (1)}$$

In Expression (1) above, $I_0$ is an intensity of parallel rays incident on the cover glass 100. In addition, I is an intensity of parallel rays transmitted through the cover glass 100.

In addition, when the time for heating the cover glass 100 in the baking step S170 is less than 10 minutes, the amount of generation of outgassing derived from the monomer contained in the antireflection layer 40 is small. In other words, when the time for heating the cover glass 100 is less than 10 minutes, a large amount of the photopolymerizable component contained in the antireflection layer 40 remains. Then, when the reflow step S 190 is performed, a large amount of the monomer-derived outgassing will be generated.

Thus, the cover glass 100 is heated for more than or equal to 10 minutes in the baking step S170 to reduce the remaining amount of the photopolymerizable component contained in the antireflection layer 40. This can reduce the amount of generation of the monomer-derived outgassing in the reflow step S190 which is the subsequent step.

Note that the time for heating the cover glass 100 in the baking step S170 preferably is less than or equal to 60 minutes. Even if the time for heating the cover glass 100 exceeds 60 minutes, the amount of generation of the monomer-derived outgassing hardly varies from that in a case in which the heating time is 60 minutes, so that energy required for heating for more than 60 minutes will be wasted. Thus, by setting the time for heating the cover glass 100 in the baking step S170 at less than or equal to 60 minutes, energy required for heating can be reduced to improve energy efficiency while ensuring the amount of generation of the monomer-derived outgassing.

The cover glass 100 according to the present embodiment is manufactured through the above steps. The cover glass 100 includes the glass substrate 10 and the antireflection layer 40 provided on the surfaces 12 and 14 on both the sides of the glass substrate 10. The antireflection layer 40 has the micro concave-convex structure 42 having an average cycle of concavities or convexities of less than or equal to the visible light wavelength and is made of the cured product 24 of the light-curing resin. The cured product 24 of the light-curing resin is a polymer of the resin (A) and the resin (B).

The content rate of the remaining monomer derived from the photopolymerizable component contained in the polymer preferably is less than or equal to 0.3 % by mass. This can maintain the parallel transmittance of the cover glass 100 high and can reduce the amount of generation of the monomer-derived outgassing in the reflow step S190. In addition, the content rate of the remaining monomer derived from the resin (A) contained in the polymer preferably is less than or equal to 0.25 % by mass. This can maintain the parallel transmittance of the cover glass 100 further higher and can further reduce the amount of generation of the monomer-derived outgassing in the reflow step S190.

[Assembling Step S180]

The assembling step S180 is a step of installing the cover glass 100 after the baking step S170 at a position opposed to a light receiving surface 222 of a sensor element 220 to assemble the sensor module 200.

As shown in FIG. 5, in the assembling step S180 of the present embodiment, the cover glass 100 is installed on a sensor unit 210 to assemble the sensor module 200. The sensor unit 210 includes the sensor element 220 and a package substrate 230.

The sensor element 220 is an image sensor, LiDAR, or the like, for example. The image sensor is a visible light image sensor, an infrared image sensor, an ultraviolet image sensor, or an X-ray image sensor, for example. The image sensor may be a CCD image sensor, a CMOS image sensor, or the like, for example.

The package substrate 230 is a ball grid array, for example. In the present embodiment, the package substrate 230 includes a storage part 232, a printed substrate 234, and solder balls 236. The storage part 232 stores the printed substrate 234. The storage part 232 is formed of epoxy resin, for example. The plurality of solder balls 236 are provided on the undersurface of the storage part 232. The plurality of solder balls 236 are connected to the printed substrate 234 via wiring lines not shown.

The sensor element 220 is placed on the printed substrate 234. In the present embodiment, a surface opposite to the light receiving surface 222 of the sensor element 220 comes into contact with the printed substrate 234. The sensor element 220 and the printed substrate 234 are connected to each other via bonding wires 234a.

As shown in FIG. 5, in the assembling step S180 according to the present embodiment, the cover glass 100 is installed on an upper part of the storage part 232 of the package substrate 230 to oppositely arrange the cover glass 100 and the sensor element 220 in a separate state, thereby assembling the sensor module 200. However, a mode of assembling the sensor module 200 is not limited to the example of FIG. 5, but another assembling mode may be adopted if it is a mode in which the cover glass 100 is installed at a position opposed to the light receiving surface 222 of the sensor element 220.

[Reflow Step S190]

The reflow step S190 is a step of placing the sensor module 200 on a mounting substrate 250 and applying heat at a temperature of more than or equal to 250°C. As shown in FIG. 6, in the present embodiment, in the reflow step S190, the mounting substrate 250 is stored in a reflow furnace RF in a state where the sensor module 200 is placed on the mounting substrate 250. Then, the inside of the reflow furnace RF is raised to a temperature of more than or equal to 250°C.

Through the heating treatment in the reflow step S190, the plurality of solder balls 236 of the sensor module 200 melt to solder the sensor module 200 to the mounting substrate 250. The electronic device 300 is thereby manufactured. In the electronic device 300, the sensor element 220 covered with the cover glass 100 is mounted on the mounting substrate 250.

As described above, according to the present embodiment, the baking step S170 is performed as a heating step which is a step preceding the reflow step S190. The rate of generation of outgassing derived from the photopolymerizable component in outgassing generated from the antireflection layer 40 of the cover glass 100 in the reflow step S190 is thus less than or equal to 0.3 % by mass to the mass of the antireflection layer 40. In addition, the rate of generation of outgassing derived from the resin (A) in outgassing generated from the antireflection layer 40 of the cover glass 100 in the reflow step S190 preferably is less than 0.2 % by mass to the mass of the antireflection layer 40.

Note that outgassing generated by heating the antireflection layer 40 to 265°C is analyzed with a gas chromatography mass spectrometer (GC-MS) and the rate of generation of outgassing is calculated based on Expressions (2) and (3) below.

$$\text{OGt [\% by mass]} = \text{PAt} \times \text{S [mg]} / \text{PAs} / \text{C [mg]} \times 100 \quad \text{... Expression (2)}$$

$$\text{OGa [\% by mass]} = \text{PAa} \times \text{S [mg]} / \text{PAs} / \text{C [mg]} \times 100 \quad \text{... Expression (3)}$$

In Expression (2) above, OGt is the rate of generation of outgassing [% by mass] derived from the photopolymerizable component. PAt is the peak area of outgassing derived from the photopolymerizable component. The peak area of outgassing is obtained with the gas chromatography mass spectrometer. In Expressions (2) and (3) above, PAs is the peak area of a reference material (for example, tetradecane) obtained with the gas chromatography mass spectrometer. S is the weight [mg] of the reference material added in measurement. C is the weight [mg] of the antireflection layer 40. In Expression (3) above, OGa is the rate of generation of outgassing [% by mass] derived from the resin (A). PAa is the peak area of outgassing derived from the resin (A). The peak area is obtained with the gas chromatography mass spectrometer.

As described above, in the method for manufacturing the electronic device 300 according to the present embodiment, a monofunctional acrylate monomer having a phenyl group is used as the resin (A) and the baking step S170 is performed before the reflow step S190. This allows the method for manufacturing the electronic device 300 according to the present embodiment to reduce the rate of generation of outgassing derived from the photopolymerizable component in outgassing generated from the antireflection layer 40 of the cover glass 100 in the reflow step S190 to less than or equal to 0.3 % by mass to the mass of the antireflection layer 40.

This can restrain generation of outgassing that may induce corrosion of a wiring material and the like in the electronic device 300 in the high-temperature reflow step (for example, 250 to 270°C). Thus, corrosion of various wiring lines and the like provided for the sensor element 220, the printed substrate 234, the bonding wires 234a, the mounting substrate 250, and the like of the electronic device 300 can be restrained.

In addition, deterioration in the optical properties of the cover glass 100 that would result from outgassing, such as, for example, yellowing of the cover glass 100 (deterioration in transmittance on the short wavelength side) and deterioration in the antireflection performance (sagging of the micro concave-convex structure 42) can be restrained. Therefore, the parallel transmittance of the cover glass 100 in the electronic device 300 can be improved, and high transmission performance of the cover glass 100 for light having a wavelength of more than or equal to 400 nm can be ensured. By increasing the transmission performance of the cover glass 100 as described above, image pickup performance of an image sensor and the like covered with the cover glass 100 can be improved.

Conventionally, there has been a problem in that, when the cover glass is formed of a resin material, the transmittance drops for light in the visible light band on the short wavelength side. In contrast, the cover glass 100 according to the present embodiment can restrain the transmittance for light in the visible light band on the short wavelength side from dropping and can ensure high transmittance for light having a wavelength of more than or equal to 400 nm.

If described specifically, in the case in which the reflow step S190 for the cover glass 100 is carried out, the parallel transmittance of the cover glass 100 for light having a wavelength of 400 nm is more than or equal to 95.5%, for example. In addition, the parallel transmittance of the cover glass 100 for light having a wavelength of 550 nm is more than or equal to 98%, for example. The parallel transmittance of the cover glass 100 for light having a wavelength of 650 nm is more than or equal to 98.5%, for example. In addition, the parallel transmittance of the cover glass 100 for light having a wavelength of 900 nm is more than or equal to 98%, for example.

Incident light from the outside can thereby be transmitted favorably through the cover glass 100 having high transmittance to reach the sensor element 220. Therefore, reduction in light receiving sensitivity of the sensor element 220 resulting from the use of the cover glass 100 made of resin can be restrained.

In addition, light reflected off the sensor element 220 can be restrained from being re-reflected off the cover glass 100. This can restrain an erroneous reaction of the sensor element 220 that would be caused by re-reflection of light off the cover glass 100.

In addition, as described above, the parallel transmittance of the cover glass 100 after the reflow step S190 is executed, that is, the parallel transmittance of the cover glass 100 of the electronic device 300, for light having a wavelength of 400 nm is more than or equal to 95.5%, for example. Therefore, the cover glass 100 can be applied to the sensor element 220 that receives not only visible light but also infrared light.

In addition, when a monofunctional acrylate monomer having a phenyl group is used as the resin (A), the heat resistance of the antireflection layer 40 can be improved. The micro concave-convex structure 42 of the antireflection layer 40 can be thus restrained from being deformed. This enables reduction in antireflection performance of the antireflection layer 40 to be avoided.

In addition, when a monomer having a ring structure in the molecule is used as the resin (B), the rate of generation of outgassing derived from the photopolymerizable component in outgassing generated from the antireflection layer 40 of the cover glass 100 in the reflow step S190 can be further reduced.

[Examples]

Hereinafter, examples of the present invention and comparative examples will be described specifically. Note that the examples described below are mere examples, and the method for manufacturing an electronic device, and the cover glass, according to the present invention are not limited to the following examples.

[Consideration of Photopolymerizable Component]

Example 1 to Example 8 and Comparative Example 1 to Comparative Example 4 were produced as cover glasses.

[Example 1]

A photopolymerizable component and a photopolymerization initiator were blended to adjust a light-curing resin composition yet to be cured. As the photopolymerizable component, the resin (A) and the resin (B) were used.

Phenylethyl acrylate (PEA) manufactured by OSAKA ORGANIC CHEMICAL INDUSTRY LTD. was used as the resin (A). PEA had a viscosity of 8.4 mPa·s at 25°C.

"DPHA" and "KAYARAD R-604" manufactured by Nippon Kayaku Co., Ltd. were used as the resin (B). "DPHA" had a viscosity of 5440 mPa·s at 25°C. "KAYARAD R-604" had a viscosity of 338 mPa·s at 25°C.

As the photopolymerization initiator, "Irgacure 184" manufactured by IGM Resins B.V. was used.

In addition, in Example 1, the resin (A) had a content rate of 20 % by mass and the resin (B) had a content rate of 80 % by mass. In addition, in the resin (B), "DPHA" had a content rate of 30 % by mass and "KAYARAD R-604" had a content rate of 50 % by mass. The photopolymerization initiator had a content rate of 3 % by mass.

The glass substrate 10 was spin-coated with a primer and heated for four minutes by a hot plate at 150°C.

Then, the above-described light-curing resin composition yet to be cured was potted on the glass substrate 10 having been subjected to the primer treatment, and the light-curing resin composition yet to be cured was covered with the master 30 from above. Thereafter, the transfer step S130 and the curing step S140 were performed with an imprinting device. The transfer step S130 and the curing step S140 were performed under the condition of 40°C all the time.

First, in the transfer step S130, the master 30 was pressurized to 1000 N for 30 seconds, and pressurization at 1000 N was maintained for 30 seconds. Then, in the curing step S140, the light-curing resin composition was exposed to light using an LED lamp, the pressure was released over 10 seconds. Subsequently, the master 30 was demolded from the light-curing resin composition on the glass substrate 10. Thereafter, the light-curing resin composition on the glass substrate 10 was exposed to light at 1000 mJ/cm$^2$ using a UV conveyor to cure the light-curing resin composition. The antireflection layer 40 made of the cured product 24 of the light-curing resin composition and having the micro concave-convex structure 42 was thereby formed on the glass substrate 10 to obtain the cover glass 100.

Subsequently, the baking step S170 was performed. In the baking step S170, the cover glass 100 was heated at 150°C for 30 minutes using a hot plate. The cover glass 100 according to Example 1 was manufactured through the above steps. Then, the reflow step S190 was performed. In the reflow step S190, the cover glass 100 was heated at 265°C for five minutes. In addition, a reliability test was carried out after the reflow step S190. In the reliability test, the cover glass 100 was heated at 125°C for 2000 hours.

[Example 2]

The cover glass 100 according to Example 2 was manufactured similarly to Example 1 except for the content rate of the resin (A) and the content rate of the resin (B) in the photopolymerizable component.
In Example 2, the resin (A) had a content rate of 30 % by mass and the resin (B) had a content rate of 70 % by mass. In addition, in the resin (B), "DPHA" had a content rate of 40 % by mass and "KAYARAD R-604" had a content rate of 30 % by mass.

[Example 3]

The cover glass 100 according to Example 3 was manufactured similarly to Example 1 except for the content rate of the resin (A) and the content rate of the resin (B) in the photopolymerizable component.
In Example 3, the resin (A) had a content rate of 40 % by mass and the resin (B) had a content rate of 60 % by mass. In addition, in the resin (B), "DPHA" had a content rate of 30 % by mass and "KAYARAD R-604" had a content rate of 30 % by mass.

[Example 4]

The cover glass 100 according to Example 4 was manufactured similarly to Example 3 except for the resin (A) in the photopolymerizable component.
In Example 4, benzyl acrylate (BZA) manufactured by OSAKA ORGANIC CHEMICAL INDUSTRY LTD. was used as the resin (A).

[Example 5]

The cover glass 100 according to Example 5 was manufactured similarly to Example 2 except for the resin (B) in the photopolymerizable component.
In Example 5, trimethylolpropane triacrylate (TMPTA) manufactured by Miwon Specialty Chemical Co., Ltd. and 1,6-hexanediol diacrylate (HDDA) manufactured by Miwon Specialty Chemical Co., Ltd. were used as the resin (B). TMPTA had a viscosity of 120 mPa·s at 25°C. HDDA had a viscosity of 6.9 mPa·s at 25°C.
In the resin (B), TMPTA had a content rate of 40 % by mass and HDDA had a content rate of 30 % by mass.

[Example 6]

The cover glass 100 according to Example 6 was manufactured similarly to Example 3 except for the resin (B) in the photopolymerizable component.
In Example 6, similarly to Example 5, trimethylolpropane triacrylate (TMPTA) manufactured by Miwon Specialty Chemical Co., Ltd. and 1,6-hexanediol diacrylate (HDDA) manufactured by Miwon Specialty Chemical Co., Ltd. were used as the resin (B).
In the resin (B), TMPTA had a content rate of 30 % by mass and HDDA had a content rate of 30 % by mass.

[Example 7]

The cover glass 100 according to Example 7 was manufactured similarly to Examples 2 and 5 except for the resin (B) in the photopolymerizable component.
In Example 7, "DPHA" manufactured by Nippon Kayaku Co., Ltd. and 1,6-hexanediol diacrylate (HDDA) manufactured by Miwon Specialty Chemical Co., Ltd. were used as the resin (B).
In the resin (B), "DPHA" had a content rate of 40 % by mass and HDDA had a content rate of 30 % by mass.

[Example 8]

The cover glass 100 according to Example 8 was manufactured similarly to Examples 3 and 6 except for the resin (B) in the photopolymerizable component.
In Example 8, "DPHA" manufactured by Nippon Kayaku Co., Ltd. and 1,6-hexanediol diacrylate (HDDA) manufactured by Miwon Specialty Chemical Co., Ltd. were used as the resin (B).
In the resin (B), "DPHA" had a content rate of 30 % by mass and HDDA had a content rate of 30 % by mass.

[Comparative Example 1]

The cover glass according to Comparative Example 1 was manufactured similarly to Example 1 except for the content rate of the resin (A) and the content rate of the resin (B) in the photopolymerizable component.

In Comparative Example 1, the resin (A) had a content rate of 10 % by mass and the resin (B) had a content rate of 90 % by mass. In addition, in the resin (B), "DPHA" had a content rate of 50 % by mass and "KAYARAD R-604" had a content rate of 40 % by mass.

[Comparative Example 2]

The cover glass according to Comparative Example 2 was manufactured similarly to Example 3 except for the resin (A) in the photopolymerizable component.

In Comparative Example 2, dicyclopentanyl methacrylate "FA513M" manufactured by Showa Denko Materials Co., Ltd. was used as the photopolymerizable component instead of the resin (A). "FA513M" had a viscosity of 11 mPa·s at 25°C. In Comparative Example 2, "FA513M" had a content rate of 40 % by mass.

[Comparative Example 3]

The cover glass according to Comparative Example 3 was manufactured similarly to Comparative Example 2 except for the resin (A) in the photopolymerizable component.

In Comparative Example 3, phenylethyl methacrylate (PEMA) manufactured by Tokyo Chemical Industry Co., Ltd. was used as the photopolymerizable component instead of the resin (A). In Comparative Example 3, PEMA had a content rate of 30 % by mass.

[Comparative Example 4]

The cover glass according to Comparative Example 4 was manufactured similarly to Example 3 except for the resin (A) in the photopolymerizable component.

In Comparative Example 4, phenylethyl methacrylate (PEMA) manufactured by Tokyo Chemical Industry Co., Ltd. was used as the photopolymerizable component instead of the resin (A). In Comparative Example 4, PEMA had a content rate of 40 % by mass.

[Measurement of Rate of Generation of Outgassing]

Outgassing generated by performing the reflow step S190 in the above-described Example 1 to Example 8 and Comparative Example 1 to Comparative Example 4 was analyzed with the gas chromatography mass spectrometer (GC-MS). Then, the rate of generation of outgassing [% by mass] derived from the photopolymerizable component was calculated using Expression (2) above. In addition, in Example 1 to Example 8 and Comparative Example 1, the rate of generation [% by mass] of outgassing derived from the resin (A) was calculated using Expression (3) above. In Comparative Examples 2 to 4, the rate of generation [% by mass] of outgassing derived from the monofunctional acrylate monomer or the monofunctional methacrylate monomer was calculated using Expression (3) above.

[Measurement of Parallel Transmittance]

In the above-described Example 1 to Example 8 and Comparative Example 1 to Comparative Example 4, the parallel transmittances of the samples after the baking step S170 was performed and before the reflow step S190 was performed were measured. In addition, in the above-described Example 1 to Example 8 and Comparative Example 1 to Comparative Example 4, the parallel transmittances of the cover glasses after the reflow step S190 was performed were measured. In addition, in the above-described Example 1 to Example 8 and Comparative Example 1 to Comparative Example 4, the parallel transmittances of the cover glasses after the reliability test was performed were measured.

The parallel transmittances were measured using "UV-Vis-NIR Spectrometer V-770" manufactured by JASCO Corporation. Then, the transmittances of the cover glasses at wavelengths of 400 nm, 550 nm, 650 nm, and 900 nm were calculated using Expression (1) above.

Table 1 below shows the rates of generation [% by mass] of outgassing derived from the whole of the photopolymerizable component, the rates of generation [% by mass] of outgassing derived from the resin (A), and the parallel transmittances of Example 1 to Example 4. Table 2 below shows the rates of generation [% by mass] of outgassing derived from the whole of the photopolymerizable component, the rates of generation [% by mass] of outgassing derived from the resin (A), and the parallel transmittances of Example 5 to Example 8. Note that, in Table 1 and Table 2, "A" indicates that the evaluation of each evaluation item was very favorable and "B" indicates that the evaluation was favorable.

[Table 1]

[Table 1]

| | | | | Example 1 | Example 2 | Example 3 | Example 4 |
|---|---|---|---|---|---|---|---|
| photopolymerizable component [mass%] | monofunctional | resin (A) | PEA | 20 | 30 | 40 | - |
| | | resin (A) | BZA | - | - | - | 40 |
| | | | FA513M | - | - | - | - |
| | | | PEMA | - | - | - | - |
| | | total | | 20 | 30 | 40 | 40 |
| | bifunctional or higher functional | resin (B) | DPHA | 30 | 40 | 30 | 30 |
| | | resin (B) | R-604 | 50 | 30 | 30 | 30 |
| | | resin (B) | TMPTA | - | - | - | - |
| | | resin (B) | HDDA | - | - | - | - |
| | | total | | 80 | 70 | 60 | 60 |
| result | outgassing [%] | whole of photopolymerizable component | | 0.115 | 0.079 | 0.070 | 0.163 |
| | | monofunctional-derived | | 0.039 | 0.045 | 0.047 | 0.055 |
| | transmittance [%] | after baking | 900 nm | 99.5 | 99.4 | 99.4 | 99.5 |
| | | | 650 nm | 99.0 | 98.9 | 99.0 | 99.0 |
| | | | 550 nm | 98.4 | 98.3 | 98.4 | 98.4 |
| | | | 400 nm | 97.4 | 97.3 | 97.7 | 96.3 |
| | | after reflow | 900 nm | 99.3 | 99.4 | 99.5 | 99.5 |
| | | | 650 nm | 99.1 | 99.1 | 99.0 | 99.2 |
| | | | 550 nm | 98.7 | 98.7 | 98.2 | 98.4 |
| | | | 400 nm | 96.9 | 97.2 | 97.3 | 95.5 |
| | | after reliability test | 900 nm | 99.3 | 99.4 | 99.3 | 99.3 |
| | | | 650 nm | 98.9 | 99.0 | 98.9 | 99.3 |
| | | | 550 nm | 98.2 | 98.5 | 98.1 | 98.4 |
| | | | 400 nm | 95.6 | 96.2 | 95.8 | 95.3 |
| | | rate of fluctuation [%] (after reflow) | 400 nm | 0.41 | 0.03 | 0.44 | 0.78 |
| | | rate of fluctuation [%] (after reliability test) | 400 nm | 1.76 | 1.03 | 1.91 | 1.02 |

(continued)

| | | | | Example 1 | Example 2 | Example 3 | Example 4 |
|---|---|---|---|---|---|---|---|
| evaluation | outgassing | | whole: ≤ 0.3% | A | A | A | B |
| | | | monofunctional-derived: ≤ 0.2% | A | A | A | B |
| | transmittance | | ≥ 96% after baking | B | B | B | B |
| | | | ≥ 95.5% after reflow | B | B | B | B |
| | | | ≥ 95.3% after reliability test | B | B | B | B |
| | heat resistance | | rate of fluctuation (after reflow): ≤ 1% | B | A | B | B |
| | | | rate of fluctuation (after reliability test): ≤ 2.5% | B | B | B | B |
| | overall | | | A | A | A | B |

[Table 2]

[Table 2]

| | | | | Example 5 | Example 6 | Example 7 | Example 8 |
|---|---|---|---|---|---|---|---|
| photopolymerizable component [mass%] | monofunctional | resin (A) | PEA | 30 | 40 | 30 | 40 |
| | | resin (A) | BZA | - | - | - | - |
| | | | FA513M | - | - | - | - |
| | | | PEMA | - | - | - | - |
| | | total | | 30 | 40 | 30 | 40 |
| | bifunctional or higher functional | resin (B) | DPHA | - | - | 40 | 30 |
| | | resin (B) | R-604 | - | - | - | - |
| | | resin (B) | TMPTA | 40 | 30 | - | - |
| | | resin (B) | HDDA | 30 | 30 | 30 | 30 |
| | | total | | 70 | 60 | 70 | 60 |
| | outgassing [%] | whole of photopolymerizable component | | 0.148 | 0.136 | 0.163 | 0.177 |
| | | monofunctional-derived | | 0.082 | 0.061 | 0.102 | 0.082 |
| | | after baking | 900 nm | 98.5 | 98.6 | 98.4 | 98.5 |
| | | | 650 nm | 99.1 | 99.1 | 99.1 | 99.2 |
| | | | 550 nm | 98.9 | 98.9 | 98.9 | 98.9 |
| | | | 400 nm | 97.5 | 97.5 | 97.3 | 97.5 |

(continued)

|  |  |  |  | Example 5 | Example 6 | Example 7 | Example 8 |
|---|---|---|---|---|---|---|---|
| result | transmittance [%] | after reflow | 900 nm | 98.2 | 98.3 | 98.3 | 98.1 |
|  |  |  | 650 nm | 98.8 | 98.8 | 98.9 | 98.7 |
|  |  |  | 550 nm | 98.6 | 98.5 | 98.6 | 98.4 |
|  |  |  | 400 nm | 97.1 | 97.1 | 96.9 | 96.5 |
|  |  | after reliability test | 900 nm | 98.2 | 98.2 | 98.0 | 98.3 |
|  |  |  | 650 nm | 98.8 | 98.8 | 98.9 | 98.8 |
|  |  |  | 550 nm | 98.7 | 98.6 | 98.6 | 98.5 |
|  |  |  | 400 nm | 97.1 | 97.0 | 96.5 | 96.9 |
|  |  | rate of fluctuation [%] (after reflow) | 400 nm | 0.40 | 0.41 | 0.40 | 1.00 |
|  |  | rate of fluctuation [%] (after reliability test) | 400 nm | 0.45 | 0.46 | 0.79 | 0.58 |
| evaluation | outgassing | whole: ≤ 0.3% | | B | B | B | B |
|  |  | monofunctional-derived: ≤ 0.2% | | B | B | B | B |
|  | transmittance | ≥ 96% after baking | | B | B | B | B |
|  |  | ≥ 95.5% after reflow | | B | B | B | B |
|  |  | ≥ 95.3% after reliability test | | B | B | B | B |
|  | heat resistance | rate of fluctuation (after reflow): ≤ 1% | | B | B | B | B |
|  |  | rate of fluctuation (after reliability test): ≤ 2.5% | | A | A | B | B |
|  | overall | | | B | B | B | B |

As shown in Examples 1 to 3 in Table 1, it was confirmed that, when PEA was used as the resin (A) and "DPHA" and "KAYARAD R-604" were used as the resin (B), the rate of generation [% by mass] of outgassing of the whole of the photopolymerizable component extremely decreased to less than or equal to 0.115%. In addition, it was confirmed that the rate of generation [% by mass] of outgassing derived from the resin (A) extremely decreased to less than or equal to 0.047%.

In addition, as shown in Examples 1 to 3, it was confirmed that, when PEA was used as the resin (A) and "DPHA" and "KAYARAD R-604" were used as the resin (B), the parallel transmittance [%] of the sample at 400 nm before the reflow step S190 was performed increased to more than or equal to 97.3%. In addition, it was confirmed that the parallel transmittance [%] of the sample at 400 nm after the reflow step S190 was performed increased to more than or equal to 96.9%. Moreover, it was confirmed that the parallel transmittance [%] of the sample at 400 nm after the reliability test was carried out increased to more than or equal to 95.6%.

In addition, as shown in Examples 1 to 3, it was confirmed that, when PEA was used as the resin (A) and "DPHA" and "KAYARAD R-604" were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to less than or equal to 0.44%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to less than or equal to 1.91%. That is, it was confirmed that the use of PEA as the resin (A) and the use of "DPHA" and "KAYARAD R-604" as the resin (B) allowed the heat resistance of the antireflection layer 40 to be improved.

In addition, as shown in Examples 2 and 3 in Table 1, it was confirmed that, when the content rate of "DPHA" was more than or equal to the content rate of "KAYARAD R-604" in the resin (B), the rate of generation [% by mass] of outgassing of the whole of the photopolymerizable component further decreased to less than or equal to 0.079%. That is, comparisons between a result of Example 1 and results of Examples 2 and 3 confirmed that the content rate of "DPHA" more than or equal to the content rate of "KAYARAD R-604" in the resin (B) allowed the rate of generation [% by mass] of outgassing of the whole of the photopolymerizable component to be further reduced.

As shown in Example 4 in Table 1, it was confirmed that, when BZA was used as the resin (A), the rate of generation [% by mass] of outgassing of the whole of the photopolymerizable component decreased to 0.163%. In addition, it was confirmed that the rate of generation [% by mass] of outgassing derived from the resin (A) decreased to 0.055%. Note that a comparison between a result of Example 4 and a result of Example 3 confirmed that the use of PEA as the resin (A) allowed the rate of generation [% by mass] of outgassing of the whole of the photopolymerizable component and the rate of generation [% by mass] of outgassing derived from the resin (A) to be reduced more than the use of BZA as the resin (A) did.

In addition, as shown in Example 4, it was confirmed that, when BZA was used as the resin (A), the parallel transmittance [%] of the sample at 400 nm before the reflow step S190 was performed increased to 96.3%. In addition, it was confirmed that the parallel transmittance [%] of the sample at 400 nm after the reflow step S190 was performed increased to 95.5%. Moreover, it was confirmed that the parallel transmittance [%] of the sample at 400 nm after the reliability test was carried out increased to 95.3%.

In addition, as shown in Example 4, it was confirmed that, when BZA was used as the resin (A), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to 0.78%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 1.02%. In addition, a comparison between a result of Example 4 and a result of Example 3 confirmed that the use of BZA as the resin (A) allowed the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was performed with respect to the parallel transmittance at 400 nm before the reflow step S190 was performed to be reduced more than the use of PEA as the resin (A) did.

In addition, as shown in Example 5 in Table 2, it was confirmed that, when PEA was used as the resin (A) and TMPTA and HDDA were used as the resin (B), the rate of generation [% by mass] of outgassing of the whole of the photopolymerizable component decreased to 0.148%. In addition, it was confirmed that the rate of generation [% by mass] of outgassing derived from the resin (A) decreased to 0.082%. Note that a comparison between a result of Example 5 and a result of Example 2 confirmed that the use of "DPHA" and "KAYARAD R-604" as the resin (B) allowed the rate of generation [% by mass] of outgassing of the whole of the photopolymerizable component and the rate of generation [% by mass] of outgassing derived from the resin (A) to be reduced more than the use of TMPTA and HDDA as the resin (B) did. That is, it was confirmed that the use of a monomer having a ring structure in the molecule as the resin (B) allowed the rate of generation [% by mass] of outgassing of the whole of the photopolymerizable component and the rate of generation [% by mass] of outgassing derived from the resin (A) to be reduced.

In addition, as shown in Example 5, it was confirmed that, when PEA was used as the resin (A) and TMPTA and HDDA were used as the resin (B), the parallel transmittance [%] of the sample at 400 nm before the reflow step S190 was performed increased to 97.5%. In addition, it was confirmed that the parallel transmittance [%] of the sample at 400 nm after the reflow step S190 was performed increased to 97.1%. Moreover, it was confirmed that the parallel transmittance [%] of the sample at 400 nm after the reliability test was carried out increased to 97.1%.

In addition, as shown in Example 5, it was confirmed that, when PEA was used as the resin (A) and TMPTA and HDDA were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to 0.40%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 0.45%.

As shown in Example 6 in Table 2, it was confirmed that, when PEA was used as the resin (A) and TMPTA and HDDA were used as the resin (B), the rate of generation [% by mass] of outgassing of the whole of the photopolymerizable component decreased to 0.136%. In addition, it was confirmed that the rate of generation [% by mass] of outgassing derived from the resin (A) decreased to 0.061%. Note that a comparison between a result of Example 6 and a result of Example 3 confirmed that the use of "DPHA" and "KAYARAD R-604" as the resin (B) allowed the rate of generation [% by mass] of outgassing of the whole of the photopolymerizable component and the rate of generation [% by mass] of outgassing derived from the resin (A) to be reduced more than the use of TMPTA and HDDA as the resin (B) did. That is, it was confirmed that the use of a monomer having a ring structure in the molecule as the resin (B) allowed the rate of generation [% by mass] of outgassing of the whole of the photopolymerizable component and the rate of generation [% by mass] of outgassing derived from the resin (A) to be reduced.

In addition, as shown in Example 6, it was confirmed that, when PEA was used as the resin (A) and TMPTA and HDDA were used as the resin (B), the parallel transmittance [%] of the sample at 400 nm before the reflow step S190 was performed increased to 97.5%. In addition, it was confirmed that the parallel transmittance [%] of the sample at 400 nm after the reflow step S190 was performed increased to 97.1%. Moreover, it was confirmed that the parallel transmittance [%] of the sample at 400 nm after the reliability test was carried out increased to 97.0%.

In addition, as shown in Example 6, it was confirmed that, when PEA was used as the resin (A) and TMPTA and HDDA were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to 0.41%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 0.46%.

As shown in Example 7 in Table 2, it was confirmed that, when PEA was used as the resin (A) and "DPHA" and HDDA were used as the resin (B), the rate of generation [% by mass] of outgassing of the whole of the photopolymerizable component decreased to 0.163%. In addition, it was confirmed that the rate of generation [% by mass] of outgassing derived from the resin (A) decreased to 0.102%. Note that a comparison between a result of Example 7 and a result of Example 2 confirmed that the use of "KAYARAD R-604" as the resin (B) in addition to "DPHA" allowed the rate of generation [% by mass] of outgassing of the whole of the photopolymerizable component and the rate of generation [% by mass] of outgassing derived from the resin (A) to be reduced more than the use of HDDA as the resin (B) in addition to "DPHA" did.

In addition, as shown in Example 7, it was confirmed that, when PEA was used as the resin (A) and "DPHA" and HDDA were used as the resin (B), the parallel transmittance [%] of the sample at 400 nm before the reflow step S190 was performed increased to 97.3%. In addition, it was confirmed that the parallel transmittance [%] of the sample at 400 nm after the reflow step S190 was performed increased to 96.9%. Moreover, it was confirmed that the parallel transmittance [%] of the sample at 400 nm after the reliability test was carried out increased to 96.5%.

In addition, as shown in Example 7, it was confirmed that, when PEA was used as the resin (A) and "DPHA" and HDDA were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to 0.40%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 0.79%.

As shown in Example 8 in Table 2, it was confirmed that, when PEA was used as the resin (A) and "DPHA" and HDDA were used as the resin (B), the rate of generation [% by mass] of outgassing of the whole of the photopolymerizable component decreased to 0.177%. In addition, it was confirmed that the rate of generation [% by mass] of outgassing derived from the resin (A) decreased to 0.082%. Note that a comparison between a result of Example 8 and a result of Example 3 confirmed that the use of "KAYARAD R-604" as the resin (B) in addition to "DPHA" allowed the rate of generation [% by mass] of outgassing of the whole of the photopolymerizable component and the rate of generation [% by mass] of outgassing derived from the resin (A) to be reduced more than the use of HDDA as the resin (B) in addition to "DPHA" did.

In addition, as shown in Example 8, it was confirmed that, when PEA was used as the resin (A) and "DPHA" and HDDA were used as the resin (B), the parallel transmittance [%] of the sample at 400 nm before the reflow step S190 was performed increased to 97.5%. In addition, it was confirmed that the parallel transmittance [%] of the sample at 400 nm after the reflow step S190 was performed increased to 96.5%. Moreover, it was confirmed that the parallel transmittance [%] of the sample at 400 nm after the reliability test was carried out increased to 96.9%.

In addition, as shown in Example 8, it was confirmed that, when PEA was used as the resin (A) and "DPHA" and HDDA were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to 1.00%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 0.58%.

In addition, as shown in Example 1 to Example 4 in Table 1 and Example 5 to Example 8 in Table 2, it was confirmed that the parallel transmittances of the samples after the baking step S170 was performed and before the reflow step S190 was performed for light having a wavelength of 550 nm, light having a wavelength of 650 nm, and light having a wavelength of 900 nm were as high as more than or equal to 98.3%. In addition, it was confirmed that the parallel transmittances of the samples after the reflow step S190 was performed for light having a wavelength of 550 nm, light having a wavelength of 650 nm, and light having a wavelength of 900 nm were as high as more than or equal to 98.1%. Moreover, it was confirmed that the parallel transmittances of the samples after the reliability test was carried out for light having a wavelength of 550 nm, light having a wavelength of 650 nm, and light having a wavelength of 900 nm were as high as more than or equal to 98.0.

Table 3 below shows the rates of generation of outgassing [% by mass] derived from the monofunctional monomer and the parallel transmittances of Comparative Example 1 to Comparative Example 4. Note that, in Table 3, "A" indicates that the evaluation of each evaluation item was very favorable, "B" indicates that the evaluation was favorable, and "C" indicates that the evaluation was unfavorable.

[Table 3]

[Table 3]

| | | | Comparative Example 1 | Comparative Example 2 | Comparative Example 3 | Comparative Example 4 |
|---|---|---|---|---|---|---|
| photopolymerizable component [mass%] | monofunctional | resin (A) PEA | 10 | - | - | - |
| | | resin (A) BZA | - | - | - | - |
| | | FA513M | - | 40 | - | - |
| | | PEMA | - | - | 30 | 40 |
| | | total | 10 | 40 | 30 | 40 |
| | bifunctional or higher functional | resin (B) DPHA | 50 | 30 | 40 | 30 |
| | | resin (B) R-604 | 40 | 30 | 30 | 30 |
| | | resin (B) TMPTA | - | - | - | - |
| | | resin (B) HDDA | - | - | - | - |
| | | total | 90 | 60 | 70 | 60 |
| | whole of photopolymerizable component | monofunctional-derived | 0.149 | 0.611 | 0.316 | 0.306 |
| outgassing [%] | | | 0.036 | 0.461 | 0.238 | 0.234 |
| result | transmittance [%] | after baking 900 nm | 99.5 | 99.5 | 98.5 | 98.5 |
| | | 650 nm | 99.3 | 99.4 | 99.2 | 99.1 |
| | | 550 nm | 98.9 | 99.1 | 98.9 | 98.9 |
| | | 400 nm | 97.9 | 98.5 | 97.4 | 97.5 |
| | | after reflow 900 nm | 99.5 | 99.3 | 98.1 | 98.2 |
| | | 650 nm | 99.4 | 99.4 | 98.8 | 98.9 |
| | | 550 nm | 98.9 | 98.9 | 98.5 | 98.7 |
| | | 400 nm | 97.3 | 95.2 | 95.7 | 96.4 |

18

(continued)

| | | | | Comparative Example 1 | Comparative Example 2 | Comparative Example 3 | Comparative Example 4 |
|---|---|---|---|---|---|---|---|
| | | after reliability test | 900 nm | 99.1 | 99.2 | 98.1 | 98.2 |
| | | | 650 nm | 99.3 | 99.5 | 98.9 | 98.9 |
| | | | 550 nm | 98.6 | 98.9 | 98.6 | 98.7 |
| | | | 400 nm | 95.1 | 93.1 | 95.4 | 96.5 |
| | | rate of fluctuation [%] (after reflow) | 400 nm | 0.64 | 3.39 | 1.75 | 1.15 |
| | | rate of fluctuation [%] (after reliability test) | 400 nm | 2.82 | 5.39 | 2.06 | 0.99 |
| evaluation | outgassing | whole: ≤ 0.3% | | B | C | C | C |
| | | monofunctional-derived: ≤ 0.2% | | A | C | C | c |
| | transmittance | ≥ 96% after baking | | B | B | B | B |
| | | ≥ 95.5% after reflow | | B | C | B | B |
| | | ≥ 95.3% after reliability test | | C | C | B | B |
| | heat resistance | rate of fluctuation (after reflow): ≤ 1% | | B | C | C | C |
| | | rate of fluctuation (after reliability test): ≤ 2.5% | | C | C | B | B |
| | overall | | | C | C | C | C |

As shown in Comparative Example 1 in Table 3, it was confirmed that, when PEA was used as the resin (A) and "DPHA" and "KAYARAD R-604" were used as the resin (B), the rate of generation [% by mass] of outgassing of the whole of the photopolymerizable component decreased to less than or equal to 0.149%. In addition, it was confirmed that the rate of generation [% by mass] of outgassing derived from the resin (A) extremely decreased to less than or equal to 0.036%.

In addition, as shown in Comparative Example 1, it was confirmed that, when PEA was used as the resin (A) and "DPHA" and "KAYARAD R-604" were used as the resin (B), the parallel transmittance [%] of the sample at 400 nm before the reflow step S190 was performed increased to 97.9%. In addition, it was confirmed that the parallel transmittance [%] of the sample at 400 nm after the reflow step S190 was performed increased to 97.3%. In contrast, it was confirmed that the parallel transmittance [%] of the sample at 400 nm after the reliability test was carried out decreased to 95.1%.

In addition, as shown in Comparative Example 1, it was confirmed that, when PEA was used as the resin (A) and "DPHA" and "KAYARAD R-604" were used as the resin (B), the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed decreased to less than or equal to 0.64%. In contrast, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased to 2.82%.

Comparisons between a result of Comparative Example 1 and results of Examples 1 to 3 confirmed that, when the resin (A) had a content rate of less than or equal to 10%, the parallel transmittance [%] of the sample at 400 nm after the reliability test was carried out decreased. In addition, it was confirmed that, when the resin (A) had a content rate of less than or equal to 10%, the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased.

In addition, as shown in Comparative Example 2 in Table 3, it was confirmed that, when "FA513M" was used as the monofunctional acrylate monomer, the rate of generation [% by mass] of outgassing of the whole of the photopolymerizable component increased to 0.611%. In addition, it was confirmed that the rate of generation [% by mass] of outgassing derived from the monofunctional acrylate monomer increased to 0.461%.

In addition, as shown in Comparative Example 2, it was confirmed that, when "FA513M" was used as the monofunctional methacrylate monomer, the parallel transmittance [%] of the sample at 400 nm before the reflow step S190 was performed increased to 98.5%. In contrast, it was confirmed that the parallel transmittance [%] of the sample at 400 nm after the reflow step S190 was performed decreased to 95.2%. Moreover, it was confirmed that the parallel transmittance [%] of the sample at 400 nm after the reliability test was carried out decreased to 93.1%.

In addition, as shown in Comparative Example 2, it was confirmed that, when "FA513M" was used as the monofunctional methacrylate monomer, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed increased to 3.39%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased to 5.39%.

A comparison between a result of Comparative Example 2 and a result of Example 3 confirmed that, when a monofunctional acrylate monomer having no phenyl group was used, the rate of generation [% by mass] of outgassing of the whole of the photopolymerizable component and the rate of generation [% by mass] outgassing derived from the monofunctional acrylate monomer increased. In addition, it was confirmed that, when a monofunctional acrylate monomer having no phenyl group was used, the parallel transmittance [%] of the sample at 400 nm after the reflow step S190 was performed and the parallel transmittance [%] of the sample at 400 nm after the reliability test was carried out decreased. Moreover, it was confirmed that, when a monofunctional acrylate monomer having no phenyl group was used, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed and the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased. That is, it was confirmed that, when a monofunctional acrylate monomer having no phenyl group was used, the heat resistance of the antireflection layer 40 decreased more than when a monofunctional acrylate monomer having a phenyl group was used.

As shown in Comparative Example 3 in Table 3, it was confirmed that, when PEMA was used as the monofunctional monomer, the rate of generation [% by mass] of outgassing of the whole of the photopolymerizable component increased to 0.316%. In addition, it was confirmed that the rate of generation [% by mass] of outgassing derived from the resin (A) increased to 0.238%.

In addition, as shown in Comparative Example 3, it was confirmed that, when PEMA was used as the monofunctional monomer, the parallel transmittance [%] of the sample at 400 nm before the reflow step S190 was performed increased to 97.4%. It was confirmed that the parallel transmittance [%] of the sample at 400 nm after the reflow step S190 was performed increased to 95.7%. Moreover, it was confirmed that the parallel transmittance [%] of the sample at 400 nm after the reliability test was carried out increased to 95.4%.

In contrast, as shown in Comparative Example 3, it was confirmed that, when PEMA was used as the monofunctional monomer, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed increased to 1.75%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased to 2.06%.

A comparison between a result of Comparative Example 3 and a result of Example 2 confirmed that, when a monofunctional methacrylate monomer having a phenyl group was used as the monofunctional monomer, the rate of generation [% by mass] of outgassing of the whole of the photopolymerizable component and the rate of generation [% by mass] of outgassing derived from the monofunctional monomer increased more than when a monofunctional acrylate monomer having a phenyl group was used. In addition, it was confirmed that, when a monofunctional methacrylate monomer was used as the monofunctional monomer, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed and the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed increased. That is, it was confirmed that, when a monofunctional methacrylate monomer having a phenyl group was used, the heat resistance of the antireflection layer 40 decreased more than when a monofunctional acrylate monomer having a phenyl group was used.

As shown in Comparative Example 4 in Table 3, it was confirmed that, when PEMA was used as the monofunctional monomer, the rate of generation [% by mass] of outgassing of the whole of the photopolymerizable component increased to 0.306%. In addition, it was confirmed that the rate of generation [% by mass] of outgassing derived from the resin (A) increased to 0.234%.

In addition, as shown in Comparative Example 4, it was confirmed that, when PEMA was used as the monofunctional monomer, the parallel transmittance [%] of the sample at 400 nm before the reflow step S190 was performed increased to 97.5%. It was confirmed that the parallel transmittance [%] of the sample at 400 nm after the reflow step S190 was performed increased to 96.4%. Moreover, it was confirmed that the parallel transmittance [%] of the sample at 400 nm after the reliability test was carried out increased to 96.5%.

In contrast, as shown in Comparative Example 4, it was confirmed that, when PEMA was used as the monofunctional monomer, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed increased to 1.15%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed reached 0.99%.

A comparison between a result of Comparative Example 4 and a result of Example 3 confirmed that, when a monofunctional methacrylate monomer having a phenyl group was used, the rate of generation [% by mass] of outgassing of the whole of the photopolymerizable component and the rate of generation [% by mass] of outgassing derived from the monofunctional monomer increased more than when a monofunctional acrylate monomer having a phenyl group was used. In addition, it was confirmed that, when a monofunctional methacrylate monomer was used, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed increased. That is, it was confirmed that, when a monofunctional methacrylate monomer having a phenyl group was used, the heat resistance of the antireflection layer 40 decreased more than when a monofunctional acrylate monomer having a phenyl group was used.

As described above, the present embodiment can achieve both reduction in the rate of generation of outgassing derived from the photopolymerizable component and the maintenance of the high parallel transmittance of the cover glass 100. Therefore, the method for manufacturing the electronic device 300 according to the present embodiment enables the parallel transmittance of the cover glass 100 to be maintained high while restraining corrosion of the electronic device 300.

[Consideration of Baking Step S170]

Example 9 to Example 15 were produced as cover glasses. As in the consideration of the photopolymerizable component above, the rate of generation of outgassing and the parallel transmittance were then measured.

[Example 9]

The cover glass 100 according to Example 9 was manufactured similarly to Example 2 except that the heating temperature was 180°C and the heating time was 30 minutes in the baking step S170.

[Example 10]

The cover glass 100 according to Example 10 was manufactured similarly to Example 2 except that the heating temperature was 200°C and the heating time was 10 minutes in the baking step S170.

[Example 11]

The cover glass 100 according to Example 11 was manufactured similarly to Example 2 except that the heating temperature was 200°C and the heating time was 15 minutes in the baking step S170.

[Example 12]

The cover glass 100 according to Example 12 was manufactured similarly to Example 2 except that the heating temperature was 200°C and the heating time was 30 minutes in the baking step S170.

[Example 13]

The cover glass 100 according to Example 13 was manufactured similarly to Example 2 except that the heating temperature was 230°C and the heating time was 10 minutes in the baking step S170.

[Example 14]

The cover glass 100 according to Example 14 was manufactured similarly to Example 2 except that the heating temperature was 230°C and the heating time was 15 minutes in the baking step S170.

[Example 15]

The cover glass 100 according to Example 15 was manufactured similarly to Example 2 except that the heating temperature was 230°C and the heating time was 30 minutes in the baking step S170.

Table 4 below shows the rates of generation [% by mass] of outgassing derived from the whole of the photopolymerizable component, the rates of generation [% by mass] of outgassing derived from the resin (A), and the parallel transmittances of Example 9 to Example 12. Table 5 below shows the rates of generation [% by mass] of outgassing derived from the whole of the photopolymerizable component, the rates of generation [% by mass] of outgassing derived from the resin (A), and the parallel transmittances of Example 13 to Example 15. Note that, in Table 4 and Table 5, "B" indicates that the evaluation of each evaluation item was favorable and "A" indicates that the evaluation was very favorable.

[Table 4]

[Table 4]

| | | | Example 9 | Example 10 | Example 11 | Example 12 |
|---|---|---|---|---|---|---|
| baking step | | temperature [°C] | 180 | 200 | 200 | 200 |
| | | time [min] | 30 | 10 | 15 | 30 |
| result | outgassing [%] | whole of photopolymerizable component | 0.175 | 0.136 | 0.118 | 0.109 |
| | | monofunctional-derived | 0.043 | 0.090 | 0.088 | 0.085 |
| | transmittance [%] | after baking 900 nm | 99.4 | 99.1 | 99.2 | 99.1 |
| | | 650 nm | 99.2 | 99.7 | 99.7 | 99.6 |
| | | 550 nm | 98.6 | 99.4 | 99.3 | 99.4 |
| | | 400 nm | 98.1 | 98.2 | 98.1 | 98.1 |
| | | after reflow 900 nm | 99.4 | 99.2 | 99.3 | 99.1 |
| | | 650 nm | 99.3 | 99.8 | 99.8 | 99.7 |
| | | 550 nm | 98.8 | 99.4 | 99.4 | 99.3 |
| | | 400 nm | 97.9 | 97.8 | 98.1 | 97.8 |
| | | after reliability test 900 nm | 99.3 | 99.0 | 99.1 | 99.0 |
| | | 650 nm | 99.3 | 99.7 | 99.8 | 99.7 |
| | | 550 nm | 98.6 | 99.4 | 99.4 | 99.4 |
| | | 400 nm | 95.7 | 97.6 | 97.9 | 97.8 |
| | | rate of fluctuation [%] (after reflow) 400 nm | 0.29 | 0.31 | -0.03 | 0.27 |
| | | rate of fluctuation [%] (after reliability test) 400 nm | 2.46 | 0.52 | 0.16 | 0.32 |
| evaluation | outgassing | whole: ≤ 0.3% | B | B | A | A |
| | | monofunctional-derived: ≤ 0.2% | A | B | B | B |
| | transmittance | ≥ 96% after baking | B | B | B | B |
| | | ≥ 95.5% after reflow | B | B | B | B |
| | | ≥ 95.3% after reliability test | B | B | B | B |
| | heat resistance | rate of fluctuation (after reflow): ≤ 1% | A | A | A | A |
| | | rate of fluctuation (after reliability test): ≤ 2.5% | B | A | A | A |
| | overall | | A | B | A | A |

[Table 5]

[Table 5]

| | | | Example 13 | Example 14 | Example 15 |
|---|---|---|---|---|---|
| baking step | | temperature [°C] | 230 | 230 | 230 |
| | | time [min] | 10 | 15 | 30 |
| result | outgassing [%] | whole of photopolymerizable component | 0.108 | 0.099 | 0.094 |
| | | monofunctional-derived | 0.084 | 0.083 | 0.081 |
| | transmittance [%] | after baking 900 nm | 99.2 | 99.1 | 99.1 |
| | | after baking 650 nm | 99.7 | 99.7 | 99.7 |
| | | after baking 550 nm | 99.5 | 99.4 | 99.5 |
| | | after baking 400 nm | 98.2 | 98.0 | 97.9 |
| | | after reflow 900 nm | 99.2 | 99.2 | 99.2 |
| | | after reflow 650 nm | 99.8 | 99.7 | 99.8 |
| | | after reflow 550 nm | 99.4 | 99.3 | 99.4 |
| | | after reflow 400 nm | 98.0 | 97.8 | 97.7 |
| | | after reliability test 900 nm | 99.0 | 99.0 | 99.0 |
| | | after reliability test 650 nm | 99.7 | 99.7 | 99.7 |
| | | after reliability test 550 nm | 99.4 | 99.4 | 99.5 |
| | | after reliability test 400 nm | 97.8 | 97.8 | 97.7 |
| | rate of fluctuation [%] (after reflow) | 400 nm | 0.13 | 0.20 | 0.21 |
| | rate of fluctuation [%] (after reliability test) | 400 nm | 0.35 | 0.15 | 0.21 |
| evaluation | outgassing | whole: ≤ 0.3% | A | A | A |
| | | monofunctional-derived: ≤ 0.2% | B | B | B |
| | transmittance | ≥ 96% after baking | B | B | B |
| | | ≥ 95.5% after reflow | B | B | B |
| | | ≥ 95.3% after reliability test | B | B | B |
| | heat resistance | rate of fluctuation (after reflow): ≤ 1% | A | A | A |
| | | rate of fluctuation (after reliability test): ≤ 2.5% | A | A | A |
| | overall | | A | A | A |

As shown in Example 9 in Table 4, it was confirmed that, when the heating temperature in the baking step S170 was 180°C, the rate of generation [% by mass] of outgassing derived from the resin (A) extremely decreased to 0.043%.

In addition, as shown in Example 9, it was confirmed that, when the heating temperature in the baking step S170 was 180°C, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed extremely decreased to 0.29%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed decreased to 2.46%.

As shown in Example 10 to Example 12 in Table 4, it was confirmed that, as the heating time in the baking step S170 increased, the rate of generation [% by mass] of outgassing derived from the whole of the photopolymerizable component and the rate of generation [% by mass] of outgassing derived from the resin (A) decreased.

In addition, as shown in Example 10 to Example 12, it was confirmed that, when the heating temperature in the baking step S170 was 200°C, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed extremely decreased to less than or equal to 0.31%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed extremely decreased to less than or equal to 0.52%.

In addition, comparisons between results of Example 10 to Example 12 and a result of Example 2 confirmed that the increased heating temperature in the baking step S170 allowed the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed to be decreased in spite of the decreased heating time.

As shown in Example 13 to Example 15 in Table 5, it was confirmed that, as the heating time in the baking step S170 increased, the rate of generation [% by mass] of outgassing derived from the whole of the photopolymerizable component and the rate of generation [% by mass] of outgassing derived from the resin (A) decreased.

In addition, as shown in Example 13 to Example 15, it was confirmed that, when the heating temperature in the baking step S170 was 230°C, the rate of fluctuation [%] (the parallel transmittance [%] at 400 nm before the reflow step S190 was performed - the parallel transmittance [%] at 400 nm after the reflow step S190 was performed) in the parallel transmittance at 400 nm after the reflow step S190 was performed with respect to the parallel transmittance at 400 nm before the reflow step S190 was performed extremely decreased to less than or equal to 0.21%. In addition, it was confirmed that the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed extremely decreased to less than or equal to 0.35%.

In addition, comparisons between results of Example 13 to Example 15 and a result of Example 2 confirmed that the increased heating temperature in the baking step S170 allowed the rate of fluctuation [%] (the parallel transmittance [%] at 400 nm before the reflow step S190 was performed - the parallel transmittance [%] at 400 nm after the reliability test was carried out) in the parallel transmittance at 400 nm after the reliability test was carried out with respect to the parallel transmittance at 400 nm before the reflow step S190 was performed to be decreased in spite of the decreased heating time.

An embodiment of the present invention has been described above with reference to the accompanying drawings, whilst it goes without saying that the present invention is not limited to the above embodiment. It is apparent that a person skilled in the art may find various alterations and modifications within the scope of the appended claims, and it should be understood that they will naturally come under the technical scope of the present invention.

For example, in the above-described embodiment, the case in which the uncured resin layer 20 is cured by radiating light to the uncured resin layer 20 while transferring the micro concave-convex structure 32 of the master 30 to the uncured resin layer 20 has been taken as an example. However, the uncured resin layer 20 may be cured by radiating light to the uncured resin layer 20 after the micro concave-convex structure 32 of the master 30 is transferred to the uncured resin layer 20.

In addition, in the above-described embodiment, the case in which the rate of generation of outgassing derived from the photopolymerizable component and the rate of generation of outgassing derived from the resin (A) are calculated using the results of the analysis obtained with the gas chromatography mass spectrometer (GC-MS) has been taken as an example. The rate of generation of outgassing derived from the photopolymerizable component and the rate of generation of outgassing derived from the resin (A) may be, however, calculated using another method.

Reference Signs List

S130  transfer step
S140  curing step
S170  baking step
S180  assembling step

S190     reflow step
10     glass substrate
12     surface
14     surface
20     uncured resin layer
30     master
32     micro concave-convex structure
40     antireflection layer
42     micro concave-convex structure
100     cover glass
200     sensor module
220     sensor element
222     light receiving surface
250     mounting substrate
300     electronic device

## Claims

1. A method for manufacturing an electronic device in which a sensor element covered with a cover glass is mounted on a mounting substrate,

   the cover glass including

   a glass substrate, and
   an antireflection layer provided on a surface on at least one side of the glass substrate and having a micro concave-convex structure having an average cycle of concavities or convexities of less than or equal to a visible light wavelength,

   the method for manufacturing comprising:

   (1) a transfer step of transferring the micro concave-convex structure of a master to an uncured resin layer provided on the surface on the at least one side of the glass substrate and made of a light-curing resin yet to be cured;
   (2) a curing step of radiating light to the uncured resin layer to which the micro concave-convex structure has been transferred to cure the uncured resin layer and form the antireflection layer made of a cured product of the light-curing resin;
   (3) a baking step of heating the cover glass on which the antireflection layer has been formed;
   (4) an assembling step of installing the cover glass after the baking step at a position opposed to a light receiving surface of the sensor element to assemble a sensor module; and
   (5) a reflow step of placing the sensor module on the mounting substrate and applying heat at a temperature of more than or equal to 250°C to solder the sensor module to the mounting substrate, wherein

   the light-curing resin yet to be cured contains a photopolymerizable component,
   the photopolymerizable component contains a resin (A) and a resin (B),
   the resin (A) is a monofunctional acrylate monomer having a phenyl group,
   the resin (B) is a bifunctional or higher functional acrylate monomer,
   the resin (A) has a content rate of more than 10 % by mass and less than or equal to 40 % by mass to a whole of the photopolymerizable component,
   the resin (B) has a content rate of more than or equal to 60 % by mass and less than 90 % by mass to the whole of the photopolymerizable component, and
   the baking step is performed before the reflow step to make a rate of generation of outgassing derived from the photopolymerizable component in outgassing generated from the antireflection layer of the cover glass in the reflow step less than or equal to 0.3 % by mass to mass of the antireflection layer.

2. The method for manufacturing an electronic device according to claim 1, wherein a rate of generation of outgassing derived from the resin (A) in the outgassing generated from the antireflection layer of the cover glass in the reflow step is less than 0.2 % by mass.

3. The method for manufacturing an electronic device according to claim 1 or 2, wherein the resin (B) is a monomer having a ring structure in a molecule.

4. The method for manufacturing an electronic device according to claim 1, wherein the cover glass on which the antireflection layer has been formed is heated at a temperature of more than or equal to 150°C and less than 250°C for more than or equal to 10 minutes in the baking step.

5. The method for manufacturing an electronic device according to claim 1, wherein

the antireflection layer is provided on each of surfaces on both sides of the glass substrate, and
the micro concave-convex structure of the master is transferred to the uncured resin layer provided on each of the surfaces on both the sides of the glass substrate in the transfer step.

6. The method for manufacturing an electronic device according to claim 1, wherein the sensor element is an image sensor.

7. A method for manufacturing an electronic device in which a sensor element covered with a cover glass is mounted on a mounting substrate,

the cover glass including

a glass substrate, and
an antireflection layer provided on a surface on at least one side of the glass substrate and having a micro concave-convex structure having an average cycle of concavities or convexities of less than or equal to a visible light wavelength,

the method for manufacturing comprising:

(1) a transfer step of transferring the micro concave-convex structure of a master to an uncured resin layer provided on the surface on the at least one side of the glass substrate and made of a light-curing resin yet to be cured;
(2) a curing step of radiating light to the uncured resin layer to which the micro concave-convex structure has been transferred to cure the uncured resin layer and form the antireflection layer made of a cured product of the light-curing resin;
(3) a baking step of heating the cover glass on which the antireflection layer has been formed;
(4) an assembling step of installing the cover glass after the baking step at a position opposed to a light receiving surface of the sensor element to assemble a sensor module; and
(5) a reflow step of placing the sensor module on the mounting substrate and applying heat at a temperature of more than or equal to 250°C to solder the sensor module to the mounting substrate, wherein

the light-curing resin yet to be cured contains a photopolymerizable component,
the photopolymerizable component contains a resin (A) and a resin (B),
the resin (A) is a monofunctional acrylate monomer having a phenyl group,
the resin (B) is a bifunctional or higher functional acrylate monomer,
the resin (A) has a content rate of more than 10 % by mass and less than or equal to 40 % by mass to a whole of the photopolymerizable component,
the resin (B) has a content rate of more than or equal to 60 % by mass and less than 90 % by mass to the whole of the photopolymerizable component, and
the cover glass on which the antireflection layer has been formed is heated at a temperature of more than or equal to 150°C and less than 250°C for more than or equal to 10 minutes in the baking step.

8. The method for manufacturing an electronic device according to claim 7, wherein the baking step is performed before the reflow step to make a rate of generation of outgassing derived from the photopolymerizable component in outgassing generated from the antireflection layer of the cover glass in the reflow step less than or equal to 0.3 % by mass to mass of the antireflection layer.

9. A cover glass that covers a sensor element mounted on a mounting substrate of an electronic device, the cover glass comprising:

a glass substrate; and

an antireflection layer provided on a surface on at least one side of the glass substrate, having a micro concave-convex structure having an average cycle of concavities or convexities of less than or equal to a visible light wavelength, and made of a cured product of a light-curing resin, wherein

the cured product of the light-curing resin is a polymer of a resin (A) and a resin (B),

the resin (A) is a monofunctional acrylate monomer having a phenyl group,

the resin (B) is a bifunctional or higher functional acrylate monomer, and

a remaining monomer derived from the resin (A) contained in the polymer has a content rate of less than or equal to 0.25 % by mass.

START

S110 CLEANING AND PRETREATMENT STEP

S120 RESIN LAYER FORMING STEP

S130 TRANSFER STEP

S140 CURING STEP

S150 DEMOLDING STEP

S160 POST-CURING STEP

S170 BAKING STEP

S180 ASSEMBLING STEP

S190 REFLOW STEP

END

FIG.1

FIG.2

FIG.3

FIG.4

FIG.5

FIG.6

## INTERNATIONAL SEARCH REPORT

| International application No. |
| --- |
| **PCT/JP2024/002392** |

| A. | CLASSIFICATION OF SUBJECT MATTER |
| --- | --- |

*H01L 27/146*(2006.01)i; *C08F 220/28*(2006.01)i; *G02B 1/118*(2015.01)i
FI: H01L27/146 D; G02B1/118; C08F220/28

According to International Patent Classification (IPC) or to both national classification and IPC

| B. | FIELDS SEARCHED |
| --- | --- |

Minimum documentation searched (classification system followed by classification symbols)

H01L27/146; C08F220/28; G02B1/118

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2013/187528 A1 (MITSUBISHI RAYON CO.) 19 December 2013 (2013-12-19) | 1-9 |
| A | WO 2019/004406 A1 (DAI NIPPON PRINTING CO., LTD.) 03 January 2019 (2019-01-03) | 1-9 |
| A | WO 2015/076309 A1 (ASAHI GLASS COMPANY, LIMITED) 28 May 2015 (2015-05-28) | 1-9 |
| A | WO 2020/067202 A1 (DEXERIALS CORPORATION) 02 April 2020 (2020-04-02) | 1-9 |
| A | JP 2021-162728 A (DEXERIALS CORPORATION) 11 October 2021 (2021-10-11) | 1-9 |
| P, A | WO 2023/032804 A1 (DEXERIALS CORPORATION) 09 March 2023 (2023-03-09) | 1-9 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 February 2024** | **12 March 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/002392**

| Patent document cited in search report | | | Publication date (day/month/year) | Patent family member(s) | | | Publication date (day/month/year) |
|---|---|---|---|---|---|---|---|
| WO | 2013/187528 | A1 | 19 December 2013 | US | 2015/0166704 | A1 | |
| | | | | EP | 2863245 | A1 | |
| | | | | KR | 10-2015-0023753 | A | |
| | | | | BR | 112014031230 | A | |
| | | | | TW | 201406527 | A | |
| | | | | JP | 2013-29828 | A | |
| WO | 2019/004406 | A1 | 03 January 2019 | JP | 2019-12266 | A | |
| WO | 2015/076309 | A1 | 28 May 2015 | JP | 2017-14303 | A | |
| | | | | TW | 201525614 | A | |
| WO | 2020/067202 | A1 | 02 April 2020 | US | 2021/0349343 | A1 | |
| | | | | EP | 3859719 | A1 | |
| | | | | CN | 112703544 | A | |
| | | | | KR | 10-2021-0040145 | A | |
| | | | | TW | 202028389 | A | |
| JP | 2021-162728 | A | 11 October 2021 | US | 2023/0124524 | A1 | |
| | | | | WO | 2021/200175 | A1 | |
| | | | | EP | 4130808 | A1 | |
| | | | | TW | 202144812 | A | |
| | | | | CN | 115552291 | A | |
| WO | 2023/032804 | A1 | 09 March 2023 | JP | 2023-37702 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015214101 A